# DEMANDE DE BREVET EUROPEEN

(11) **EP 4 346 005 A1**
(43) Date de publication de la demande: **03.04.2024**
(21) Numéro de dépôt: 23199641.4
(22) Date de dépôt: 26.09.2023
(51) Int. Cl.: H01P 1/10, H10N 70/20, H10N 70/00

(54) **COMMUTATEUR RADIOFREQUENCE**

(30) Priorité: 30.09.2022 FR 2209989
(71) Demandeur: Commissariat à l'énergie atomique et aux énergies alternatives, 75015 Paris (FR)
(72) Inventeur: CLARET, Thierry, 38054 Grenoble Cedex 09 (FR); REIG, Bruno, 38054 Grenoble Cedex 09 (FR); CLARET, Thierry, 38054 Grenoble Cedex 09 (FR)
(74) Mandataire: Cabinet Camus Lebkiri

(57) **Abrégé**

L'invention a pour objet un commutateur (100) radiofréquence apte à établir ou rompre la transmission d'un signal radiofréquence, ledit commutateur (100) comportant un premier doigt conducteur (101), un deuxième doigt conducteur (102), la transmission dudit signal radiofréquence se faisant entre le premier doigt conducteur (101) et le deuxième doigt conducteur (102), au moins une électrode conductrice (103) et une couche réalisée dans un matériau PCM (104) présentant une surface inférieure et une surface supérieure. Lesdits premier et deuxième doigt conducteur (101, 102) sont espacés d'une distance non nulle (L1) et en contact avec la surface inférieure de la couche PCM (104). L'électrode conductrice (103) est en contact avec la surface supérieure de la couche PCM (104).

## Description

### DOMAINE TECHNIQUE DE L'INVENTION

La présente invention est relative aux commutateurs radiofréquences utilisés notamment mais non exclusivement dans le domaine des télécommunications.

### ARRIERE-PLAN TECHNOLOGIQUE DE L'INVENTION

Dans le domaine des télécommunications sans fil, les développements se sont orientés vers la conception d'architectures radiofréquences (RF) flexibles avec l'intégration de composants agiles en fréquence (filtres et antennes accordables). Une solution connue pour assurer cette agilité consiste à utiliser des composants dits commutateurs radiofréquences (ou « RF switch » selon la terminologie anglaise) pour permettre notamment l'adaptation de la réponse des dispositifs à plusieurs fréquences. Un commutateur RF permet non seulement d'assurer l'accord en fréquence mais aussi de sélectionner le trajet d'un signal dans un dispositif ou un réseau de commutation. De façon plus générale, les commutateurs RF servent de dispositif de sélection de bandes de fréquences dans des modules d'émission-réception, de dispositif assurant la reconfiguration de la fréquence d'utilisation ou du diagramme de rayonnement d'une antenne, de dispositif de routage entre une partie réceptrice et une partie émettrice ou encore de dispositif d'adaptation d'impédance, notamment capacitive.

Un commutateur RF est un commutateur fonctionnant dans le domaine des radiofréquences (i.e. de quelques kHz à plusieurs centaines de GHz), voire au-delà dans le cas d'applications de l'ordre de quelques THz pour de l'imagerie médicale.

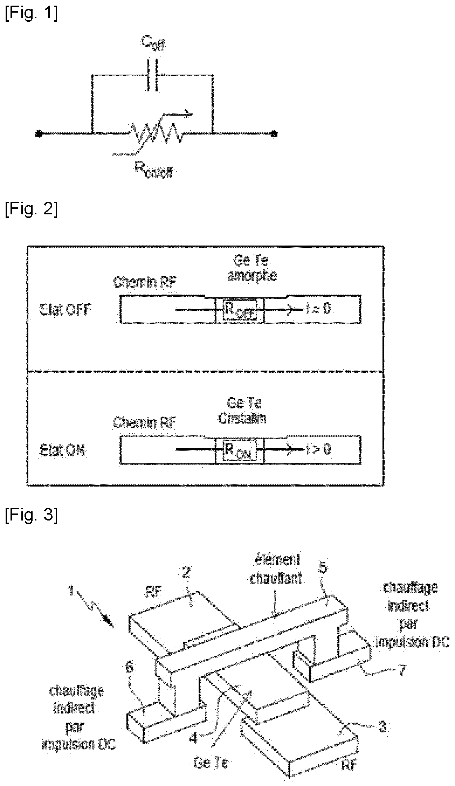

Ce type de commutateur peut être représenté par un circuit équivalent, tel qu'illustré en figure 1, qui présente à l'état passant (bassement résistif) dit « état ON », une résistance Ron et à l'état bloqué (hautement résistif) dit « état OFF », une capacité Coff. Les performances électriques d'un commutateur RF sont évaluées à travers les valeurs de Ron et de Coff mais également à travers la valeur de la résistance Roff à l'état OFF. La valeur de Ron renseigne sur les pertes d'insertion à l'état passant (ON) : plus Ron est faible plus les pertes sont minimales. La valeur de Coff renseigne sur le niveau d'isolation à l'état bloqué (OFF) : plus la valeur de Coff est faible, plus le niveau d'isolation est élevé. Outre une valeur de Ron faible et une valeur de Coff faible, on cherchera également à avoir une valeur de Roff la plus élevée possible et donc un ratio Roff/Ron le plus élevé possible. Les performances des commutateurs RF peuvent être caractérisées par une figure de mérite FoM (« Figure of Mérité » selon la terminologie anglaise) définie par : FoM=Ron x Coff exprimée en femtoseconde. Plus la FoM est faible, plus les performances du commutateur se rapprochent de celles d'un commutateur idéal. On trouve dans la littérature également une autre expression de la FoM appelée fréquence de coupure (« CutOff Frequency » selon la terminologie anglaise Fc définie par : Fc = 1/ (2π Ron x Coff) exprimée en THz qui traduit aussi les performances électriques du commutateur : plus la valeur de Fc est grande, plus les performances du commutateur se rapprochent de celles d'un commutateur idéal. De plus, l'efficacité d'un commutateur dépend aussi de sa vitesse de commutation entre les deux états, de sa consommation en énergie, de sa taille, de sa tenue en puissance, de sa fiabilité et de sa capacité à s'intégrer dans un process de fabrication CMOS.

La technologie la plus utilisée pour la réalisation des commutateurs RF est actuellement basée sur les semiconducteurs et plus particulièrement sur les transistors MOS (« Metal Oxide Semiconductor » selon la terminologie anglaise) sur substrat SOI (Silicium sur Isolant ou « Silicon On Insulator » selon la terminologie anglaise). Cette technologie donne de bons résultats, notamment en termes de fiabilité et d'endurance, de faible énergie nécessaire à la commutation (comprise entre 50 fJ et 10pJ) et de temps de commutation rapide (compris entre 1 et 100 ns) mais présente des limitations en termes de figure de mérite avec une FoM pouvant aller de 0.5 à 2 THz. Un autre inconvénient de cette technologie concerne la nécessité d'appliquer une tension statique de commande de la grille du transistor tant qu'on souhaite maintenir celui-ci dans un état spécifique ; en d'autres termes, la technologie est volatile et entraîne une consommation d'énergie statique.

On connait également des commutateurs RF à base de dispositifs MEMS (Microsystème électromécanique) qui présentent de bonnes performances électriques et une FoM pouvant atteindre 50 THz. L'inconvénient de ce type de composant réside dans un temps de commutation élevé (au mieux 1 µs).

Une autre technologie connue pour la réalisation des commutateurs RF repose sur l'utilisation de matériaux à changement de phase PCM (« Phase Change Materials » selon la terminologie anglaise) tels que les matériaux chalcogénures de type GeTe. Le principe des matériaux PCM repose sur un changement réversible du matériau d'un état amorphe (avec un arrangement désordonné d'atomes) à un état cristallin (avec un arrangement ordonné d'atomes). La différence structurale entre l'état amorphe et l'état cristallin se traduit par un changement des propriétés électriques du matériau. A l'état amorphe le matériau présente une forte résistivité électrique et à l'état cristallin, le matériau est caractérisé par une faible résistivité électrique. Le fonctionnement d'un commutateur RF PCM est illustré en figure 2. Le commutateur est un dispositif dans lequel les deux électrodes RF sont connectées à une zone réalisée dans un matériau PCM tel que du GeTe, ladite zone pouvant être soit dans un état Roff (i.e. hautement résistif) lorsque le matériau PCM est dans un état amorphe soit dans un état Ron (i.e. faiblement résistif) lorsque le matériau PCM est dans un état cristallin. La commutation réversible entre l'état cristallin et l'état amorphe est obtenue par un traitement thermique spécifique (i.e. chauffage ou refroidissement du matériau de façon contrôlée) obtenu par l'envoi d'impulsions électriques dans un élément chauffant. Les deux états amorphe et cristallin étant stables, il n'est pas nécessaire de maintenir un courant/tension de commande pour maintenir un état de sorte que le commutateur RF PCM a un comportement non volatil, offrant dès lors une solution efficace pour diminuer la consommation d'énergie. Les commutateurs RF PCM présentent par ailleurs des FoM meilleures que celles des transistors et un grand contraste en résistivité entre les deux états ainsi qu'une très faible résistivité à l'état cristallin permettant de réaliser des commutateurs ayant de faibles pertes d'insertion.

On connait deux catégories de commutateurs RF PCM : les premiers sont dits à actionnement indirect tandis que les seconds sont dits à actionnement direct.

Un exemple de commutateur à actionnement indirect est illustré en figure 3. Le commutateur 1 de la figure 3 comporte deux électrodes RF 2 et 3 reliées entre elles par un motif PCM 4. Le commutateur 1 comporte également un élément chauffant 5 (ou « heater » selon la terminologie anglaise) agencé orthogonalement à la ligne RF et qui n'est pas en contact avec le motif PCM 4. On retrouve généralement un matériau diélectrique (non représenté ici) entre l'élément chauffant 5 et le motif PCM 4. La couche de diélectrique joue un double rôle. Elle permet d'une part d'isoler électriquement l'élément chauffant du reste du circuit (électrodes RF 2 et 3 et matériau PCM 4) et d'autre part, de coupler thermiquement l'élément chauffant 5 et le motif PCM 4. Le chauffage du matériau PCM est indirect, car les impulsions électriques d'actionnement sont appliquées au niveau de l'élément chauffant (qui n'est pas en contact électrique avec le matériau PCM) via ses entrée/sortie 6 et 7. L'élément chauffant 5 chauffe par effet Joule et la chaleur générée est transmise indirectement par radiation thermique vers le motif PCM 4 à travers la couche de diélectrique. Par conséquent, le matériau PCM change de propriétés électriques (résistivité) modifiant ainsi l'impédance vue entre les deux électrodes RF 2 et 3. Le matériau diélectrique doit être un isolant électrique le plus épais possible pour limiter les capacités parasites entre l'élément chauffant d'un côté et le motif PCM et les électrodes RF de l'autre. Il doit également être un conducteur thermique le plus fin possible pour que la température nécessaire au changement de phase passe le plus rapidement entre l'élément chauffant et le motif PCM avec un moindre cout énergétique. Il faut donc trouver le meilleur compromis pour l'épaisseur de diélectrique entre la conductivité thermique et l'isolation électrique.

Un exemple de réalisation d'une structure à actionnement indirect est notamment décrite dans l'article « A four-terminal, inline, chalcogenide phase-change RF switch using an indépendant résistive heater for thermal actuation » (El-Hinnawy et al., Electron Device Letters, 2013) dans lequel l'élément chauffant est localisée sous le motif PCM. On connait également d'autres commutateurs RF à actionnement indirect dans lesquels l'élément chauffant est situé au-dessus du motif PCM. Les principaux inconvénients des commutateurs PCM à actionnement indirect résident dans le temps de commutation (de l'ordre de 100 à 1000 ns) qui reste élevé par rapport aux technologies semiconductrices (du fait du volume important de matériau PCM à commuter) et la consommation en puissance importante (de l'ordre de 1 à 500 nJ) nécessaire pour faire transiter le matériau entre les deux états.

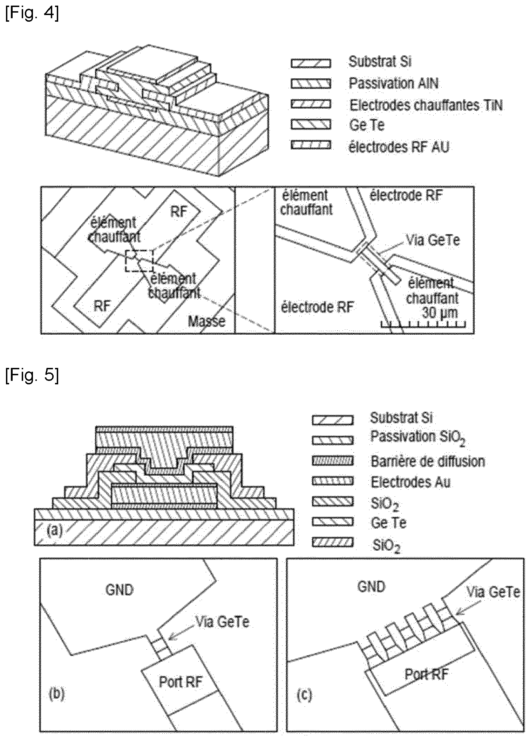

Afin de limiter la consommation en puissance, l'article « Directly heated four-terminal phase changes switches » (Wang et al. IEEE MTT-S Int. Symp., June 2014) décrit une structure de commutateur RF PCM à actionnement direct telle qu'illustrée en figure 4. Le dispositif est un commutateur à quatre terminaux métalliques : deux électrodes RF et deux électrodes DC utilisées pour le chauffage du matériau PCM. Comme le montre la figure 4, une couche de GeTe est connectée horizontalement aux électrodes RF en Au (constituant le chemin RF horizontal) et verticalement aux électrodes DC en TiN (constituant le chemin de chauffage vertical). Pour faire transiter le GeTe entre l'état cristallin et l'état amorphe, des impulsions en courant sont appliquées entre les deux électrodes résistives de chauffage en TiN et la chaleur induite par effet joule est transmise directement au matériau qui change de propriété. Ici c'est donc la densité de courant amenée par les électrodes de chauffage à travers le matériau PCM qui produit l'échauffement nécessaire au changement de phase. Ainsi, l'impédance vue entre les deux électrodes va commuter entre une forte valeur et une faible valeur suivant l'état du GeTe (amorphe ou cristallin). La structure de la figure 4 permet d'améliorer la consommation en puissance. Toutefois, le temps de commutation reste long du fait du volume de matériau PCM utilisé dans chaque via où il est déposé.

L'article « RF switches using phase change material » (Shim et al., IEEE Int. Conf. Microeletromech. Syst., Jan. 2013) décrit un autre exemple d'architecture de commutateur RF PCM à actionnement direct illustrée en figure 5. Le commutateur comporte ici des électrodes RF en or (Au) qui font également office d'électrodes de chauffage pour actionner le motif de GeTe disposé entre les deux électrodes. Le signal RF et l'impulsion de courant DC d'actionnement suivent donc le même chemin vertical. Comme dans l'exemple précédent, le temps de commutation reste long du fait du volume de matériau PCM utilisé dans chaque via où il est déposé. Une telle architecture nécessite par ailleurs d'utiliser plusieurs vias recevant chacun un motif de GeTe afin de diminuer la résistance Ron : il est dès lors difficile de faire commuter l'ensemble des vias, notamment lorsque l'un d'entre eux a basculé à l'état ON.

Le changement de phase est obtenu par une impulsion thermique créée par effet joule à partir d'une impulsion de courant dans l'élément chauffant (chauffage indirect) ou directement dans le matériau (chauffage direct). Pour passer de l'état amorphe à l'état cristallin le matériau PCM est chauffé à des températures relativement faibles (environ 150°C à 350°C selon le type de matériau utilisé) pendant un temps relativement long (de l'ordre de la µ-seconde) afin que le matériau se réorganise dans son état cristallin. Pour passer d'un état cristallin à un état amorphe, le matériau est chauffé à des températures élevées (de 600 à 1000°C selon le type de matériau utilisé) pendant un lapse de temps plus court (de la dizaine à la centaine de nanosecondes) pour amener le matériau à la fusion. Puis le signal est coupé afin que le matériau refroidisse suffisamment vite pour obtenir une trempe thermique du matériau. Le matériau PCM se fige alors dans un état amorphe sans avoir le temps de reformer un cristal

On connait d'autres commutateurs RF PCM à actionnement direct décrits notamment dans les publications suivantes : « RF Power-Handling Performance for Direct Actuation of Germanium Telluride Switches » (Leon et al. - 31 Octobre 2019) - « Development and évaluation of germanium telluride phase change material based ohmic switches for RF applications » (Wang et al. - 3 novembre 2016) et « Phase Change Material (PCM) RF Switches With Integrated Decoupling Bias Circuit » (Bettoumi et al. - 5 octobre 2021).

### RESUME DE L'INVENTION

Il existe donc un besoin d'un commutateur RF à base de PCM présentant des FoM comparables à celles des commutateurs RF à base de PCM connus tout en limitant la consommation de puissance nécessaire à la commutation et en réduisant le temps de commutation.

Pour ce faire, l'invention a pour objet un commutateur apte à établir ou rompre la transmission d'un signal radiofréquence, ledit commutateur comportant :
- Un premier doigt conducteur ;
- Un deuxième doigt conducteur, la transmission dudit signal radiofréquence se faisant entre le premier doigt conducteur et le deuxième doigt conducteur
- Au moins une électrode conductrice ;
- Une couche réalisée dans un matériau à changement de phase, dite couche PCM, le matériau à changement de phase étant apte à changer d'état entre un état cristallin et un état amorphe, ladite couche PCM présentant une surface inférieure et une surface supérieure ;
- Lesdits premier et deuxième doigt conducteur étant espacés d'une distance non nulle et en contact avec la surface inférieure de la couche PCM ;
- Ladite électrode conductrice étant en contact avec la surface supérieure de la couche PCM ;
- L'acheminement d'un signal d'actionnement à-travers la couche PCM entre le premier doigt conducteur et l'électrode conductrice modifiant l'état du matériau à changement de phase dans une première zone située entre le premier doigt conducteur et l'électrode conductrice ;
- L'acheminement d'un signal d'actionnement à-travers la couche PCM entre le second doigt conducteur et l'électrode conductrice modifiant l'état du matériau à changement de phase dans une seconde zone située entre le second doigt conducteur et l'électrode conductrice ;
- de telle sorte que lorsque les première et deuxième zones du matériau à changement de phase sont dans l'état cristallin elles permettent l'acheminement du signal radiofréquence entre le premier doigt conducteur et le deuxième doigt conducteur à-travers la couche PCM et lorsque les première et deuxième zones du matériau à changement de phase sont dans l'état amorphe elles empêchent l'acheminement du signal radiofréquence entre le premier doigt conducteur et le deuxième doigt conducteur à-travers la couche PCM.

L'invention repose sur la réalisation d'un commutateur RF PCM à partir d'une extrapolation de la technologie utilisée pour la réalisation des mémoires résistives non volatiles de type PCRAM (« Phase Change RAM » selon la terminologie anglaise) mais en utilisant l'équivalent d'au moins deux points mémoires en série sur une même couche continue en matériau PCM.

Ainsi, contrairement aux commutateurs RF PCM connus de l'état de l'art nécessitant le basculement complet ou quasi complet d'un état à l'autre pour le bon fonctionnement du commutateur (i.e. pour avoir des ratios Roff/Ron suffisamment élevés), le commutateur selon l'invention repose sur le basculement d'au moins deux zones vers le même état, lesdites deux zones pouvant au non se recouvrir partiellement. En d'autres termes, le commutateur selon l'invention ne nécessite pas le basculement complet du matériau de la couche PCM dans son état cristallin ou amorphe mais seulement le basculement de deux zones réalisées dans une même couche PCM. Chacune des deux zones est réalisée entre la surface supérieure et la surface inférieure de la couche PCM (i.e. verticalement par rapport au plan horizontal de la couche PCM). Pour ce faire, on utilise au moins trois éléments conducteurs différents formés respectivement par le premier et le deuxième doigt conducteur et l'électrode conductrice :
- le premier doigt conducteur inférieur et l'électrode supérieure permettent la commande de la première zone ;
- le deuxième doigt conducteur et l'électrode supérieure permettent la commande de la deuxième zone ;
- lorsque les deux zones sont dans l'état cristallin, un signal radiofréquence peut être transmis entre le premier et le deuxième doigt tandis que lorsque les deux zones dans l'état amorphe, le signal radiofréquence ne peut être transmis. Le signal radiofréquence rentre donc par la surface inférieure de la couche PCM via le premier doigt puis circule le long du plan horizontal de la couche PCM pour sortir via le second doigt.

Comme nous le détaillerons dans la suite de la description, le fait d'avoir au moins deux zones commandées permet d'augmenter sensiblement (au moins d'un facteur 10, voire d'un facteur 100 ou plus) le ratio Roff/Ron par rapport au ratio Roff/Ron d'une mémoire PCRAM standard et donc d'obtenir des ratios Roff/Ron tout à fait compatibles avec des exigences des commutateurs RF. De même, grâce à l'invention, on obtient des valeurs de Ron plus basses que pour des mémoires PCRAM standards. Enfin, l'invention permet d'avoir des temps de commutation comparables à ceux des mémoires PCRAM standards, de l'ordre de 10 à 100 ns pour passer de la phase amorphe à la phase cristalline (versus environ 1 microseconde pour les commutateurs RF PCM de l'état de l'art) et de l'ordre de 10 ns pour passer de la phase cristalline à la phase amorphe (versus environ 100 ns pour les commutateurs RF PCM de l'état de l'art). Le commutateur selon l'invention permet donc de gagner au moins un facteur 10 sur le temps de commutation par rapport aux commutateurs RF PCM de l'état de l'art. On notera que le commutateur RF selon l'invention est un commutateur à actionnement direct au sens où c'est la densité de courant amenée à travers le matériau PCM par les éléments de chauffage, formés par les doigts inférieurs et l'électrode supérieure, qui produit l'échauffement nécessaire au changement de phase.

Comme expliqué précédemment, on entend par commutateur radiofréquence un commutateur fonctionnant dans le domaine des radiofréquences (i.e. de quelques kHz à plusieurs centaines de GHz), voire au-delà dans le cas d'applications de l'ordre de quelques THz ou dizaines de THz pour de l'imagerie.

Le commutateur selon l'invention peut également présenter une ou plusieurs des caractéristiques ci-dessous, considérées individuellement ou selon toutes les combinaisons techniquement possibles :
- Le matériau à changement de phase est choisi parmi l'un au moins des matériaux suivants : GeTe, GeSbTe, SbTe, GeTeN.
- les premier et deuxième doigt conducteur sont espacés d'une longueur comprise entre 10 nm et 200 nm.
- chacun des premier et deuxième doigt conducteur repose respectivement sur un premier et un deuxième élément conducteur de connexion, un premier et un deuxième pilier conducteur respectivement d'entrée et de sortie du signal radiofréquence reposant également respectivement sur lesdits premier et deuxième élément conducteur de connexion.
- lesdits premier et deuxième élément conducteur de connexion repose respectivement sur un autre élément conducteur adapté pour être connecté à un circuit de pilotage indépendant des premier et un deuxième pilier conducteur d'entrée et de sortie du signal radiofréquence, tel qu'un pilier de sortie d'un transistor CMOS.
- ledit premier doigt conducteur et/ou ledit deuxième doigt conducteur et/ou ladite électrode conductrice est connecté à un premier moyen de découplage entre le signal radiofréquence et le signal d'actionnement tel qu'un condensateur permettant de bloquer le signal radiofréquence.
- ledit premier doigt conducteur et/ou ledit deuxième doigt conducteur est connecté à un deuxième moyen de découplage entre le signal radiofréquence et le signal d'actionnement tel qu'une inductance permettant de bloquer le signal d'actionnement.
- le commutateur selon l'invention comporte une pluralité N, supérieure ou égale à 3, de doigts conducteurs espacés d'une distance non nulle et en contact avec la surface inférieure de la couche PCM, lesdits premier et deuxième doigt appartenant à ladite pluralité N de doigts, l'acheminement d'un signal d'actionnement à-travers la couche PCM entre chaque doigt conducteur et l'électrode conductrice modifiant l'état du matériau à changement de phase dans une zone située entre le doigt conducteur et l'électrode conductrice.

L'invention a également pour objet un procédé d'actionnement d'un commutateur selon l'invention comportant :
- une étape d'acheminement d'un signal d'actionnement d'un premier type à-travers la couche PCM entre le premier doigt conducteur et l'électrode conductrice modifiant l'état du matériau à changement de phase dans une première zone située entre le premier doigt conducteur et l'électrode conductrice ;
- une étape d'acheminement d'un signal d'actionnement du premier type à-travers la couche PCM entre le second doigt conducteur et l'électrode conductrice modifiant l'état du matériau à changement de phase dans une seconde zone située entre le second doigt conducteur et l'électrode conductrice ;
- un étape d'acheminement d'un signal d'actionnement d'un second type entre le premier doigt conducteur et le deuxième doigt conducteur, ledit signal d'actionnement d'un second type visant à corriger l'état du matériau PCM dans les première et deuxième zones.

L'invention a également pour objet un système de commutation comportant une pluralité de commutateurs selon l'invention montés en série.

Le système de commutation selon l'invention peut également comporter une pluralité de commutateurs selon l'invention montés en parallèle.

Le système de commutation selon l'invention peut également comporter une matrice incluant une pluralité de commutateurs selon l'invention montés en parallèle et une pluralité de commutateurs selon l'invention montés en série.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
[Fig. 1] représente un circuit équivalent d'un commutateur RF.
[Fig. 2] illustre le fonctionnement d'un commutateur RF PCM selon l'art antérieur.
[Fig. 3] représente un exemple de commutateur RF PCM à actionnement indirect selon l'art antérieur.
[Fig. 4] représente un premier exemple de commutateur RF PCM à actionnement direct selon l'art antérieur.
[Fig. 5] représente un deuxième exemple de commutateur RF PCM à actionnement direct selon l'art antérieur.
[Fig. 6] représente un commutateur RF PCM à actionnement direct selon l'invention.
[Fig. 7] et [Fig. 8] illustrent les deux états de fonctionnement ON et OFF du commutateur de la [Fig. 6].
[Fig. 9] illustre l'état OFF du commutateur de la [Fig. 6] avec deux zones amorphes disjointes.
[Fig. 10], [Fig. 11] et [Fig. 12] illustrent les différences entre le fonctionnement d'une mémoire PCRAM de l'état de l'art et celui du commutateur selon l'invention.
[Fig. 13] illustre un premier mode de réalisation des moyens de découplage entre le signal RF et le signal d'actionnement dans un commutateur selon l'invention.
[Fig. 14] illustre un second mode de réalisation des moyens de découplage entre le signal RF et le signal d'actionnement dans un commutateur selon l'invention.
[Fig. 15] illustre un troisième mode de réalisation des moyens de découplage entre le signal RF et le signal d'actionnement dans un commutateur selon l'invention.

### DESCRIPTION DETAILLEE

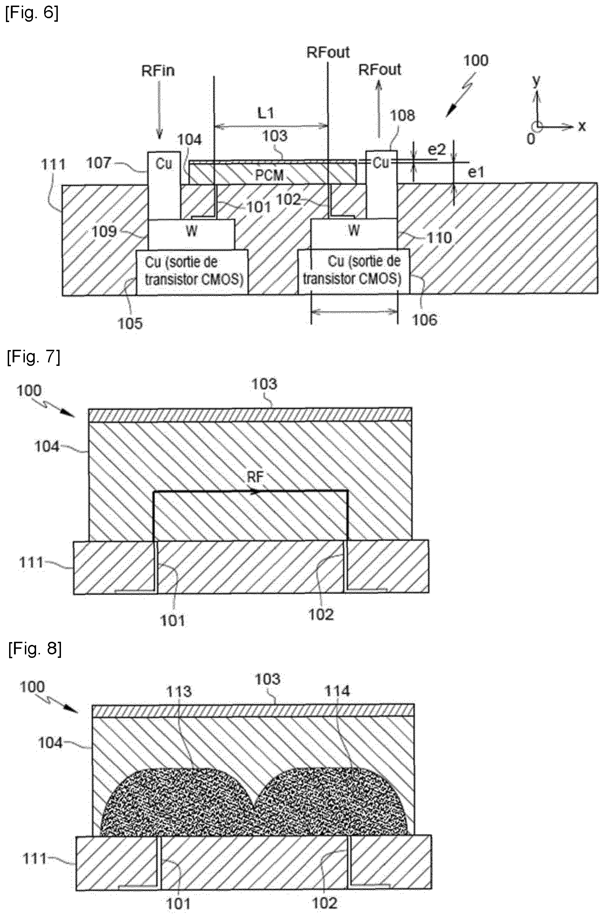

La figure 6 représente un commutateur radiofréquence 100 selon l'invention illustré dans un plan Oxy.

Le commutateur 100 comporte :
- Un premier doigt conducteur 101 ;
- Un deuxième doigt conducteur 102 ;
- Une électrode conductrice 103 ;
- Une couche réalisée dans un matériau à changement de phase 104, dite couche PCM;
- Un premier plot métallique de sortie transistor 105 ;
- Un deuxième plot métallique de sortie transistor 106 ;
- Un pilier d'entrée du signal RF 107 ;
- Un pilier de sortie du signal RF 108 ;
- Un premier via de connexion 109 ;
- Un deuxième via de connexion 110.

De manière avantageuse, la fabrication du commutateur 100 selon l'invention est compatible avec la technologie CMOS. Les deux plots de sortie CMOS 105 et 106 sont ainsi des plots de sortie, par exemple en cuivre, issus de la fabrication d'un transistor CMOS et sont par exemple reliés à la source ou au drain d'un transistor CMOS : les transistors CMOS peuvent permettre de commander l'actionnement du commutateur 100 selon l'invention comme nous le verrons par la suite. Sur chacun des deux plots de sortie CMOS 105 et 106 repose respectivement un via de connexion (premier et deuxième via de connexion 109 et 110) réalisé par exemple en tungstène.

Le pilier d'entrée du signal RF 107 est déposé sur le via de connexion 109 et le pilier de sortie du signal RF 108 est déposé sur le via de connexion 110. Les deux piliers 107 et 108 sont par exemple réalisés en cuivre, chacun ayant une surface inférieure en contact avec la surface supérieure du via 109 ou 110 sur lequel il est déposé.

Le premier doigt conducteur 101 est déposé sur le via de connexion 109 et sa base est en contact avec la surface supérieure du premier via de connexion 109. L'extrémité supérieure du premier doigt conducteur 101 est en contact avec la surface inférieure de la couche PCM 104. De façon illustrative et non limitative, le premier doigt conducteur a par exemple une forme en L avec une première branche horizontale (i.e. suivant l'axe Ox) en contact avec la surface supérieure du premier via de connexion 109 et une deuxième branche verticale (i.e. suivant l'axe Oy) en contact avec la surface inférieure de la couche PCM 104.

Le deuxième doigt conducteur 102 est déposé sur le via de connexion 110 et sa base est en contact avec la surface supérieure du deuxième via de connexion 110. L'extrémité supérieure du deuxième doigt conducteur 102 est en contact avec la surface inférieure de la couche PCM 104. Comme le premier doigt conducteur, de façon illustrative et non limitative, le deuxième doigt conducteur a par exemple une forme en L avec une première branche horizontale (i.e. suivant l'axe Ox) en contact avec la surface supérieure du deuxième via de connexion 110 et une deuxième branche verticale (i.e. suivant l'axe Oy) en contact avec la surface inférieure de la couche PCM 104.

Les zones de contact des premier et deuxième doigt conducteur avec la surface inférieure de la couche PCM 104 sont espacées horizontalement d'une longueur L1 par exemple comprise entre 10 et 200 nm et préférentiellement de l'ordre de 50 nm.

On notera que le commutateur 100 est réalisé par une succession de dépôts de couches, de gravures et de polissage non représentés ici mais connus de l'homme du métier. Ainsi, l'ensemble des éléments conducteurs sont entourés d'une zone isolante 111 formée par une ou plusieurs couches diélectriques, des oxydes ou des nitrures par exemple. Les premier et deuxième via de connexion 109 et 110 assurent la connexion électrique entre la zone inférieure de sortie des transistors CMOS et la zone supérieure de commutation RF.

L'électrode conductrice 103 est déposée sur la surface supérieure de la couche PCM 104. La surface inférieure de l'électrode conductrice 103 est en regard suivant l'axe Oy des zones de contact des premier et deuxième doigt conducteur avec la surface inférieure de la couche PCM 104. On notera qu'une seule électrode conductrice 103 a été représentée ici. L'invention s'appliquerait également au cas de deux électrodes conductrices disposées sur la surface supérieure de la couche PCM, chacune respectivement en regard des zones de contact des premier et deuxième doigt conducteur avec la surface inférieure de la couche PCM. L'épaisseur e1 de la couche PCM mesurée suivant l'axe Oy est par exemple comprise entre 25 et 100 nm, et préférentiellement de l'ordre de 50 nm. On notera que la couche PCM 104 est une couche continue en matériau PCM ; en d'autres termes, elle est constituée uniquement d'un matériau PCM ou plusieurs matériaux PCM sans interruption par une zone dans un matériau non PCM. Le matériau PCM utilisé peut être un matériau chalcogénure tel que du GeTe, du GeSbTe, du SbTe ou du GeTeN : cette liste est donnée à titre purement illustratif et non limitatif.

L'ensemble formé par les premier et deuxième doigt conducteur 101 et 102 et l'électrode conductrice supérieure 103 forme des moyens de chauffage adaptés pour actionner le commutateur 100 de façon réversible d'un premier état passant à un deuxième état bloqué comme nous allons le détailler dans ce qui suit.

Les figures 7 et 8 illustrent les deux états de fonctionnement ON (état bassement résistif) et OFF (état hautement résistif) du commutateur 100 de la figure 6.

Sur la figure 7, le commutateur 100 est à l'état passant. Le matériau PCM de la couche PCM 104 est à l'état cristallin de sorte qu'il permet l'acheminement 112 d'un signal radiofréquence entre le premier doigt conducteur 101 et le deuxième doigt conducteur 102 à travers la couche PCM 104. Comme nous le verrons par la suite, des éléments de découplage entre le signal RF et le signal d'actionnement du commutateur peuvent s'avérer nécessaire afin d'éviter que le signal RF ne s'achemine vers l'électrode conductrice 103. On note que, contrairement au commutateur à actionnement direct RF PCM de l'état de l'art, le chemin suivi par le signal RF est ici sensiblement horizontal (i.e. suivant la direction Ox parallèle au plan de la couche PCM 104).

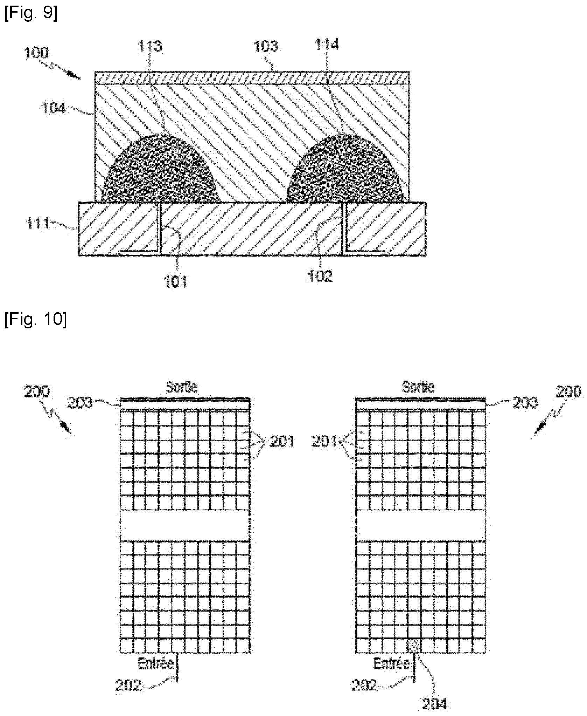

Comme illustré en figure 8, lorsqu'un signal d'actionnement correspondant à une impulsion de courant DC pendant un laps de temps très court (i.e. quelques nanosecondes) est émis entre le premier doigt 101 et l'électrode conductrice 103, le matériau PCM est chauffé pour arriver partiellement à la fusion. Le signal est alors coupé afin que le matériau refroidisse suffisamment vite pour obtenir une trempe thermique du matériau. Le matériau PCM se fige alors dans un état amorphe sans avoir le temps de reformer le cristal : ce changement d'état se produit dans une zone située entre le premier doigt 101 et l'électrode conductrice 103 de manière à former une première zone amorphe 113. L'opération est répétée entre le deuxième doigt 101 et l'électrode conductrice 103 de manière à former une deuxième zone amorphe 114. On notera que les deux zones amorphes 113 et 114 se recoupent ici mais que le commutateur selon l'invention fonctionnerait également avec deux zones amorphes disjointes telles que représentées en figure 9. Les première et deuxième zones du matériau à changement de phase 113 et 114 étant dans l'état amorphe, elles empêchent l'acheminement du signal radiofréquence entre le premier doigt conducteur 101 et le deuxième doigt conducteur 102. Le commutateur 100 selon l'invention est alors à l'état bloqué.

Pour revenir à l'état passant, un autre signal d'actionnement sous la forme d'une impulsion de courant DC pendant un laps de temps plus long que le précédent signal d'actionnement (i.e. d'une dizaine à une centaine de nanosecondes) est émis entre le premier doigt 101 et l'électrode conductrice 103 afin que le matériau PCM de la zone 113 se réorganise dans son état cristallin. La même opération est réalisée entre le deuxième doigt 102 et l'électrode conductrice 103 afin que le matériau PCM de la zone 114 se réorganise dans son état cristallin. Le commutateur 100 se retrouve alors dans l'état passant tel qu'illustré en figure 7.

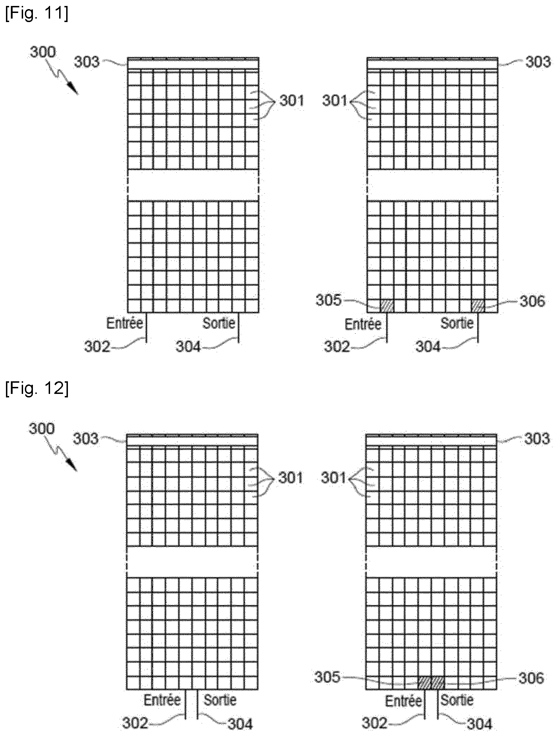

On note ici que le commutateur 100 selon l'invention utilise avantageusement le principe de fonctionnement d'une mémoire de type PCRAM mais avec au moins deux zones mémoires contrairement à une mémoire PCRAM qui n'en a qu'une. Le commutateur 100 selon l'invention se distingue également des commutateurs RF PCM de l'état de l'art en ce qu'il ne nécessite pas de commuter tout le volume du matériau PCM. L'obtention de ces deux zones mémoires est obtenue grâce à la présence des trois terminaux (les deux doigts 101 et 102 sur la surface inférieure de la couche PCM 104 et l'électrode conductrice 103 sur la surface supérieure de la couche PCM 104) agencés de façon à créer et défaire les zones amorphes 113 et 114. La présence de ces deux zones mémoires permet à la structure de répondre aux exigences d'un commutateur RF notamment en termes de ratio Roff/Ron contrairement aux mémoires PCRAM qui présentent des ratios Roff/Ron bien trop faibles (i.e. de l'ordre de 100) : le commutateur selon l'invention permet ainsi d'obtenir un ratio Roff/Ron supérieur à 1000, voire à 10000. Cette différence entre le fonctionnement d'une mémoire PCRAM connue et celui du commutateur selon l'invention est illustrée de manière schématique en référence aux figures 10 et 11.

La figure 10 représente schématiquement une zone 200 de matériau PCM décomposée en 100 mailles élémentaires carrées 201. A gauche, les 100 mailles élémentaires sont à l'état cristallin. Chaque maille élémentaire ayant sensiblement une résistance élémentaire de 1 Ohms à l'état cristallin, la zone 200 a une résistance Ron à l'état ON sensiblement égale à 100 Ohms (100 mailles élémentaires en série). Cette résistance Ron est la résistance entre le doigt d'entrée inférieur 202 et l'électrode supérieure 203. A droite, la maille élémentaire 204 situé au niveau du doigt 202 commute de l'état cristallin à l'état amorphe. Chaque maille élémentaire ayant sensiblement une résistance élémentaire de 10 kOhms à l'état amorphe, la zone 200 a une résistance Roff à l'état OFF sensiblement égale à 10099 Ohms (99 mailles élémentaires à 1 Ohms et 1 maille élémentaire à 10 kOhms en série). Cette résistance Roff est la résistance entre le doigt d'entrée inférieur 202 et l'électrode supérieure 203. Selon cette configuration, le ratio Roff/Ron est donc sensiblement égal à 100 (100099/100). On retrouve ici une configuration qui est celle des mémoires PCRAM standards avec une électrode inférieure (doigt inférieur 202) et une électrode supérieure 203. Un tel ratio n'est pas compatible avec une application utilisant un commutateur RF.

La figure 11 représente schématiquement une zone 300 de matériau PCM décomposée en 100 mailles élémentaires carrées 301. A gauche, les 100 mailles élémentaires sont à l'état cristallin. Chaque maille élémentaire ayant sensiblement une résistance élémentaire de 1 Ohms à l'état cristallin, la zone 200 a une résistance Ron à l'état ON mesurée entre le doigt d'entrée inférieur 302 et le doigt de sortie inférieure 304 sensiblement égale à 7 Ohm (deux demi carrés en série ayant chacun une résistance de 0,5 Ohm au niveau des doigts d'entrée 302 et de sortie 304 et 6 carrés plein ayant chacun une résistance de 1 Ohm). A droite, les deux mailles élémentaires 305 et 306 situées respectivement au niveau du doigt d'entrée 302 et du doigt de sortie 304 commutent de l'état cristallin à l'état amorphe. Chaque maille élémentaire ayant sensiblement une résistance élémentaire de 10 kOhms à l'état amorphe, la zone 300 a une résistance Roff à l'état OFF mesurée entre les doigts d'entrée 302 et de sortie 304 sensiblement égale à 10006 Ohms (deux demi carrés en série ayant chacun une résistance de 5000 Ohms au niveau des doigts d'entrée 302 et de sortie 304 et 6 carrés plein ayant chacun une résistance de 1 Ohm). Selon cette configuration, le ratio Roff/Ron est donc sensiblement égal à 1429 (100006/7). On voit donc qu'on gagne ici un facteur supérieur à 10 entre la configuration de la figure 11 et celle de la figure 10. La commutation des zones élémentaires 305 et 306 est obtenue en appliquant une impulsion d'actionnement respectivement entre le doigt d'entrée 302 et l'électrode supérieure 303 et entre le doigt de sortie 304 et l'électrode supérieure 303. Les doigts d'entrée et de sortie 302 et 304 sont assimilables aux premier et deuxième doigt 101 et 102 de la figure 6 tandis que l'électrode supérieure 303 est assimilable à l'électrode conductrice 103 de la figure 6.

Le ratio Roff/Ron peut être encore augmenté en rapprochant les doigts d'entrée et de sortie 302 et 304 comme cela est illustré en figure 12. Dans ce cas, on passe d'une résistance Ron de 1 Ohm (les deux demi carrés au niveau des doigts 302 et 304) à une résistance Roff de 10000 Ohms (les deux demi carrés ayant commuté à l'état amorphe et ayant chacun une résistance de 5000 Ohms). Dans ce cas, le ratio Roff/Ron est sensiblement égal à 10000. On gagne cette fois un facteur 100 par rapport à la configuration de mémoire PCRAM de la figure 10.

On comprend donc que le commutateur selon l'invention utilise avantageusement la structure d'une mémoire PCRAM comportant deux électrodes de doigts permettant de créer deux zones mémoire à l'aide d'une troisième électrode supérieure, une telle configuration permettant de conserver les avantages d'une mémoire PCRAM en termes de temps de commutation tout en gagnant au moins un facteur 10, voire 100 ou plus, sur le ratio Roff/Ron.

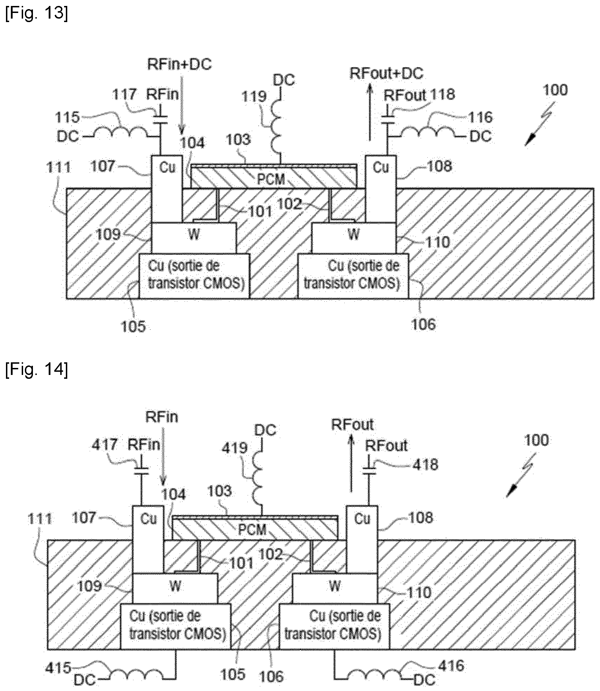

Comme nous l'avons déjà mentionné, des éléments de découplage entre le signal RF et le signal d'actionnement du commutateur peuvent s'avérer nécessaires afin d'éviter que le signal RF ne s'achemine vers l'électrode conductrice 103 de la figure 6. Un exemple d'un tel découplage est illustré en figure 13 (les éléments communs avec la figure 6 portent les mêmes références). De façon générale, il s'agit d'empêcher la transmission de signaux d'actionnement (impulsion de courant DC permettant de passer de l'état cristallin à l'état amorphe et réciproquement) vers les éléments conducteurs destinés à véhiculer un signal RF et de bloquer la transmission de signaux RF vers les éléments conducteurs destinés uniquement aux moyens de chauffage. Ici, des inductances 115, 116, 119 sont respectivement reliées en série aux piliers de cuivre 107 et 108 (et donc avec les premier et deuxième doigt 101 et 102) et à l'électrode supérieure 103 de sorte que seuls les signaux de chauffage peuvent passer à-travers lesdites inductances, les signaux RF étant bloqués. De même, des condensateurs 117 et 118 sont respectivement reliés en série aux piliers de cuivre 107 et 108 (et donc avec les premier et deuxième doigt 101 et 102) de sorte que seuls les signaux RF peuvent passer à travers lesdites condensateurs, les signaux d'actionnement DC étant bloqués. L'inductance 119 notamment permet d'éviter que le signal RF ne passe par l'électrode conductrice supérieure 103, le cheminement du signal RF se faisant entre le premier doigt 101 et le deuxième doigt 102. Les couples condensateur 117 et inductance 115 (respectivement condensateur 118 et inductance 116) forment des moyens de découplage des signaux RF et DC au niveau du pilier conducteur d'entrée du signal RF 107 (respectivement du pilier de sortie du signal RF 108) : il est ainsi possible d'injecter une impulsion DC d'actionnement du matériau PCM entre le pilier conducteur d'entrée du signal RF 107 et l'électrode supérieure 103 et une impulsion DC d'actionnement du matériau PCM entre le pilier conducteur de sortie du signal RF 108 et l'électrode supérieure 103 tout en conservant les fonctions d'entrée/sortie du signal RF des piliers 107 et 108. Selon une alternative possible, les inductances peuvent être remplacées par des résistances dont la valeur est choisie pour bloquer les signaux RF.

Les signaux d'actionnement (i.e. les impulsions de courant DC) permettant le chauffage du matériau PCM sont réalisés entre chacun des doigts conducteurs et l'électrode conductrice supérieure. Dans la mesure où chacun des doigts est connecté à la fois à un pilier conducteur d'entrée/sortie RF et à un plot métallique de sortie CMOS, ces impulsions peuvent être réalisées entre le pilier conducteur d'entrée/sortie RF et l'électrode conductrice (cas de la figure 13) mais également entre le plot métallique de sortie CMOS et l'électrode conductrice : ce mode de réalisation est illustré en figure 14. Ici, une inductance 419 est reliée en série à l'électrode supérieure 103 de sorte que seuls les signaux de chauffage peuvent passer à-travers cette inductance, les signaux RF étant bloqués. De même, des condensateurs 417 et 418 sont respectivement reliés en série aux piliers de cuivre 107 et 108 (et donc avec les premier et deuxième doigt 101 et 102) de sorte que seuls les signaux RF peuvent passer à-travers lesdites condensateurs, les signaux d'actionnement DC étant bloqués. Enfin, des inductances 415 et 416 sont respectivement reliées en série avec les plots métalliques de sortie CMOS 105 et 106 (et donc avec les premier et deuxième doigt 101 et 102) de sorte que seuls les signaux de chauffage peuvent passer à-travers cette inductance, les signaux RF étant bloqués. Selon ce mode de réalisation, les signaux d'actionnement des deux zones de commutation sont réalisés respectivement entre chaque pilier de sortie du transistor CMOS 105, 106 et l'électrode supérieure conductrice 103. Comme précédemment, les condensateurs 417 et 418 permettent de bloquer les signaux d'actionnement. Selon ce mode de réalisation, on utilise avantageusement les transistors CMOS enterrés sous la structure pour actionner le commutateur. Comme évoqué précédemment, les piliers de sortie de transistors sont par exemple reliés au drain ou à la source du transistor.

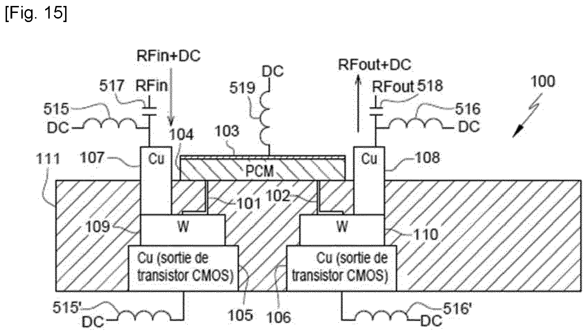

Selon une variante de réalisation, il est également possible d'avoir une combinaison des modes de réalisation décrits en référence aux figures 13 et 14. Ce mode de réalisation est illustré en figure 15. En figure 15, des inductances 515, 516, 519, 515', 516' sont respectivement reliées en série :
- aux piliers de cuivre 107 et 108 (et donc avec les premier et deuxième doigt 101 et 102) ;
- à l'électrode supérieure 103 ;
- avec les plots métalliques de sortie CMOS 105 et 106 (et donc avec les premier et deuxième doigt 101 et 102),
de sorte que seuls les signaux de chauffage peuvent passer à-travers lesdites inductances, les signaux RF étant bloqués. Des condensateurs 517 et 518 sont respectivement reliés en série aux piliers de cuivre 107 et 108 de sorte que seuls les signaux RF peuvent passer à-travers lesdits condensateurs, les signaux d'actionnement DC étant bloqués. Il est ainsi possible d'injecter un premier type de signal d'actionnement du matériau PCM à la fois entre les plots métalliques de sortie CMOS 105 et 106 et l'électrode supérieure 103 de façon à former ou défaire les zones amorphes mais aussi d'injecter directement un second type de signal d'actionnement entre le pilier conducteur d'entrée 107 du signal RF et le pilier 108 conducteur de sortie du signal RF. Contrairement au premier type de signal d'actionnement injecté verticalement, le second type de signal d'actionnement est injecté horizontalement entre les deux piliers 107 et 108. L'intérêt de ce second type de signal d'actionnement est expliqué dans ce qui suit. L'injection d'un signal d'actionnement du premier type entre les plots métalliques de sortie CMOS 105 et 106 et l'électrode supérieure 103 permet de créer ou défaire verticalement les deux zones amorphes : faisons l'hypothèse que ces deux zones amorphes sont disjointes telles que représentées en figure 9. L'injection d'une impulsion complémentaire (i.e. du deuxième type) horizontale permet d'augmenter horizontalement le volume des zones amorphes de sorte qu'elles se rejoignent comme c'est le cas sur la figure 8.

Inversement, lorsqu'une impulsion d'actionnement visant à défaire les zones amorphes est injectée entre les plots métalliques de sortie CMOS 105 et 106 et l'électrode supérieure 103, il se peut que le changement de phase ne soit pas totalement réversible et qu'il reste de faibles zones amorphes présentes dans la couche PCM. A nouveau, l'injection d'une impulsion complémentaire horizontale permet de supprimer ces zones amorphes restantes où le changement de phase vers la cristallisation n'a pas totalement opéré via un actionnement vertical seul.

En d'autres termes, le signal d'actionnement d'un second type acheminé horizontalement dans la couche PCM entre le premier et le second doigt est un signal visant à corriger l'état des deux zones créées par les signaux d'actionnement du premier type.

Même si le ratio Roff/Ron du commutateur RF selon l'invention est compatible avec les applications RF, il peut s'avérer utile de diminuer encore la valeur de la résistance Ron lorsque le commutateur est passant pour diminuer les pertes d'insertion. Pour ce faire, l'invention a également pour objet un système de commutation comportant une pluralité de commutateurs 100 selon l'invention montés en parallèle. De façon symétrique, il peut également s'avérer utile d'augmenter l'isolation du commutateur en augmentant la valeur de la résistance Roff. Le système de commutation selon l'invention peut alors comporter une pluralité de commutateurs 100 selon l'invention montés en série. Le système de commutation peut également avoir une structure matricielle avec des lignes de commutateurs selon l'invention montés en série et des colonnes de commutateurs selon l'invention montés en parallèle.

## Revendications

1. Commutateur (100) apte à établir ou rompre la transmission d'un signal radiofréquence, ledit commutateur (100) comportant :
- Un premier doigt conducteur (101) ;
- Un deuxième doigt conducteur (102), la transmission dudit signal radiofréquence se faisant entre le premier doigt conducteur (101) et le deuxième doigt conducteur (102) ;
- Au moins une électrode conductrice (103) ;
- Une couche réalisée dans un matériau à changement de phase, dite couche PCM (104), le matériau à changement de phase étant apte à changer d'état entre un état cristallin et un état amorphe, ladite couche PCM présentant une surface inférieure et une surface supérieure ;
- Lesdits premier et deuxième doigt conducteur (101, 102) étant espacés d'une distance non nulle (L1) et en contact avec la surface inférieure de la couche PCM (104) ;
le commutateur étant **caractérisé en ce que** ladite électrode conductrice (103) est en contact avec la surface supérieure de la couche PCM (104) et les doigts conducteurs, la couche PCM et l'électrode conductrice sont adaptés pour permettre :
- L'acheminement d'un signal d'actionnement à-travers la couche PCM (104) entre le premier doigt conducteur (101) et l'électrode conductrice (103) modifiant l'état du matériau à changement de phase dans une première zone située entre le premier doigt conducteur (101) et l'électrode conductrice (103) ;
- L'acheminement d'un signal d'actionnement à-travers la couche PCM (104) entre le second doigt conducteur (102) et l'électrode conductrice (103) modifiant l'état du matériau à changement de phase dans une seconde zone située entre le second doigt conducteur (102) et l'électrode conductrice (103) ;
- de telle sorte que lorsque les première et deuxième zones du matériau à changement de phase sont dans l'état cristallin elles permettent l'acheminement du signal radiofréquence entre le premier doigt conducteur (101) et le deuxième doigt conducteur (102) à-travers la couche PCM (104) et lorsque les première et deuxième zones du matériau à changement de phase sont dans l'état amorphe elles empêchent l'acheminement du signal radiofréquence entre le premier doigt conducteur (101) et le deuxième doigt conducteur (102) à-travers la couche PCM (104).

2. Commutateur selon la revendication précédente **caractérisé en ce que** le matériau à changement de phase est choisi parmi l'un au moins des matériaux suivants : GeTe, GeSbTe, SbTe, GeTeN.

3. Commutateur selon l'une des revendications précédentes **caractérisé en ce que** les premier et deuxième doigt conducteur sont espacés d'une longueur comprise entre 10 nm et 200 nm.

4. Commutateur selon l'une des revendications précédentes **caractérisé en ce que** chacun des premier et deuxième doigt conducteur repose respectivement sur un premier et un deuxième élément conducteur de connexion, un premier et un deuxième pilier conducteur respectivement d'entrée et de sortie du signal radiofréquence reposant également respectivement sur lesdits premier et deuxième élément conducteur de connexion.

5. Commutateur selon la revendication précédente **caractérisé en ce que** lesdits premier et deuxième élément conducteur de connexion repose respectivement sur un autre élément conducteur adapté pour être connecté à un circuit de pilotage indépendant des premier et un deuxième pilier conducteur d'entrée et de sortie du signal radiofréquence, tel qu'un pilier de sortie d'un transistor CMOS.

6. Commutateur selon l'une des revendications précédentes **caractérisé en ce que** ledit premier doigt conducteur et/ou ledit deuxième doigt conducteur et/ou ladite électrode conductrice est connecté à un premier moyen de découplage entre le signal radiofréquence et le signal d'actionnement tel qu'un condensateur permettant de bloquer le signal radiofréquence.

7. Commutateur selon l'une des revendications précédentes **caractérisé en ce que** ledit premier doigt conducteur et/ou ledit deuxième doigt conducteur est connecté à un deuxième moyen de découplage entre le signal radiofréquence et le signal d'actionnement tel qu'une inductance permettant de bloquer le signal d'actionnement.

8. Commutateur selon l'une des revendications précédentes **caractérisé en ce qu'**il comporte une pluralité N, supérieure ou égale à 3, de doigts conducteurs espacés d'une distance non nulle et en contact avec la surface inférieure de la couche PCM, lesdits premier et deuxième doigt appartenant à ladite pluralité N de doigts,
l'acheminement d'un signal d'actionnement à-travers la couche PCM entre chaque doigt conducteur et l'électrode conductrice modifiant l'état du matériau à changement de phase dans une zone située entre le doigt conducteur et l'électrode conductrice.

9. Procédé d'actionnement d'un commutateur selon l'une des revendications précédentes **caractérisé en ce qu'**il comporte :
- une étape d'acheminement d'un signal d'actionnement d'un premier type à-travers la couche PCM entre le premier doigt conducteur et l'électrode conductrice modifiant l'état du matériau à changement de phase dans une première zone située entre le premier doigt conducteur et l'électrode conductrice ;
- une étape d'acheminement d'un signal d'actionnement du premier type à-travers la couche PCM entre le second doigt conducteur et l'électrode conductrice modifiant l'état du matériau à changement de phase dans une seconde zone située entre le second doigt conducteur et l'électrode conductrice ;
- un étape d'acheminement d'un signal d'actionnement d'un second type entre le premier doigt conducteur et le deuxième doigt conducteur, ledit signal d'actionnement d'un second type visant à corriger l'état du matériau PCM dans les première et deuxième zones.

10. Système de commutation **caractérisé en ce qu'**il comporte une pluralité de commutateurs selon l'une des revendications 1 à 8 montés en série.

11. Système selon la revendication précédente **caractérisé en ce qu'**il comporte une pluralité de commutateurs selon l'une des revendications 1 à 8 montés en parallèle.

12. Système selon l'une des revendications 10 ou 11 **caractérisé en ce qu'**il comporte une matrice incluant une pluralité de commutateurs selon l'une des revendications 1 à 8 montés en parallèle et une pluralité de commutateurs selon l'une des revendications 1 à 8 montés en série.
